# EUROPEAN PATENT APPLICATION

(11) **EP 1 450 418 A2**
(43) Date of publication of application: **25.08.2004**
(21) Application number: 04003656.8
(22) Date of filing: 18.02.2004
(51) Int. Cl.: H01L 51/20, G02F 1/13357

(54) **Area light emitting device, method for manufacturing the same, and liquid crystal display unit**

(30) Priority: 19.02.2003 JP 2003040632
(71) Applicant: Kabushiki Kaisha Toyoda Jidoshokki, Kariya-shi, Aichi-ken (JP)
(72) Inventor: Takeuchi, Norihito, Kariya-shi Aichi-ken (JP); Isogai, Fumikazu, Kariya-shi Aichi-ken (JP); Ishikawa, Haruyuki, Kariya-shi Aichi-ken (JP); Niida, Eiki, Kariya-shi Aichi-ken (JP); Yoshida, Mikio, Kariya-shi Aichi-ken (JP); Koike, Shuji, Kariya-shi Aichi-ken (JP); Takeuchi, Kazuyoshi, Kariya-shi Aichi-ken (JP)
(74) Representative: Trösch, Hans-Ludwig

(57) **Abstract**

A backlight in a liquid crystal display unit according to the present invention has a transparent substrate and an organic electroluminescent element provided on the transparent substrate. The backlight emits light emitted from the organic electroluminescent element from a light exit surface of the transparent substrate. A plurality of recesses are formed in the light exit surface. A part of the light exit surface between each adjacent pair of the recesses includes a plane that is perpendicular to the thickness direction of the transparent substrate. The backlight permits light emitted from the organic electroluminescent element to be efficiently emitted.

## Description

### BACKGROUND OF THE INVENTION

The present invention relates to an area light emitting device emitting light through an area, a method for manufacturing such a light emitting device, and a liquid crystal display unit having such a light emitting device.

A typical area light emitting device has an area light emitting element emitting light through an area. Light from such an area light emitting element is emitted through a flat substrate. In this case, only 20 to 25% of light from the light emitting element exits the light emitting device. That is, the light emitting device is unable to efficiently emit light emitted from the light emitting element. This is because a great proportion of light from the light emitting element is reflected on an interface between the flat substrate and air.

In an organic EL device disclosed in Fig. 11 of Japanese Laid-Open Patent Publication No. 2001-135477, a plano-convex lens is formed in each section of a substrate that corresponds to a pixel, thereby increasing the proportion of light that exits the organic EL device. In the light emitting device disclosed in Japanese Laid-Open Patent Publication No. 2002-8850, light scatterers, which are asperities formed by etching a transparent film, are provided on a substrate to increase the proportion of light that exits the light emitting device.

### SUMMARY OF THE INVENTION

Accordingly, it is an objective of the present invention to provide a novel area light emitting device that is capable of efficiently emitting light emitted from a light emitting element, and a method for manufacturing such an area light emitting device. Another objective of the present invention is to provide a liquid crystal display unit provided with such an area light emitting device.

To achieve the foregoing and other objectives and in accordance with the purpose of the present invention, an area light emitting device is provided. The device includes a transparent substrate having a predetermined thickness and an area light emitting element provided on the transparent substrate. The transparent substrate includes a light exit surface. Light emitted from the element advances through the transparent substrate and exits the device through the light exit surface. A plurality of recesses are located on the light exit surface. A part of the light exit surface between each adjacent pair of the recesses includes a plane that is perpendicular to the thickness direction of the transparent substrate.

The present invention also provides another area light emitting device. The device includes a transparent substrate and an area light emitting element provided on the transparent substrate. The transparent substrate includes a light exit surface. Light emitted from the element advances through the transparent substrate and exits the device through the light exit surface. A plurality of recesses are located on the light exit surface. The recesses are formed by processing the light exit surface. A part of the light exit surface between each adjacent pair of the recesses includes a portion that is not subjected to the process for forming the recesses.

In another aspect of the present invention, a method for manufacturing an area light emitting device is provided. The device includes a transparent substrate and an area light emitting element provided on the transparent substrate. The transparent substrate includes a light exit surface. Light emitted from the element advances through the transparent substrate and exits the device through the light exit surface. The method includes: masking a part of the light exit surface with a mask; sandblasting the light exit surface, which is masked, thereby forming a plurality of recesses in the light exit surface; and removing the mask after the sandblasting.

The present invention provides another method for manufacturing an area light emitting device. The device includes a transparent substrate and an organic electroluminescent element. The transparent substrate includes a light exit surface. Light emitted from the element advances through the transparent substrate and exits the device through the light exit surface. The method includes: forming the organic electroluminescent element on the transparent substrate; sealing the organic electroluminescent element on the transparent substrate; masking a part of the light exit surface of the transparent substrate, on which the organic electroluminescent element is formed, with a mask; sandblasting the light exit surface, which is masked, thereby forming a plurality of recesses in the light exit surface; and removing the mask after the sandblasting.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1(a) is a diagrammatic cross-sectional view showing a liquid crystal display unit according to one embodiment of the present invention;
Fig. 1(b) is a plan view showing a portion of a transparent substrate of the liquid crystal display unit shown in Fig. 1(a);
Fig. 1(c) is a cross-sectional view showing recesses in the liquid crystal display unit shown in Fig. 1(a); and
Fig. 2 is a schematic cross-sectional view for explaining paths of light in the liquid crystal display unit shown in Fig. 1(a).

### DETAILED DESCRIPTION OF THE PREFERRED EMBODIMENTS

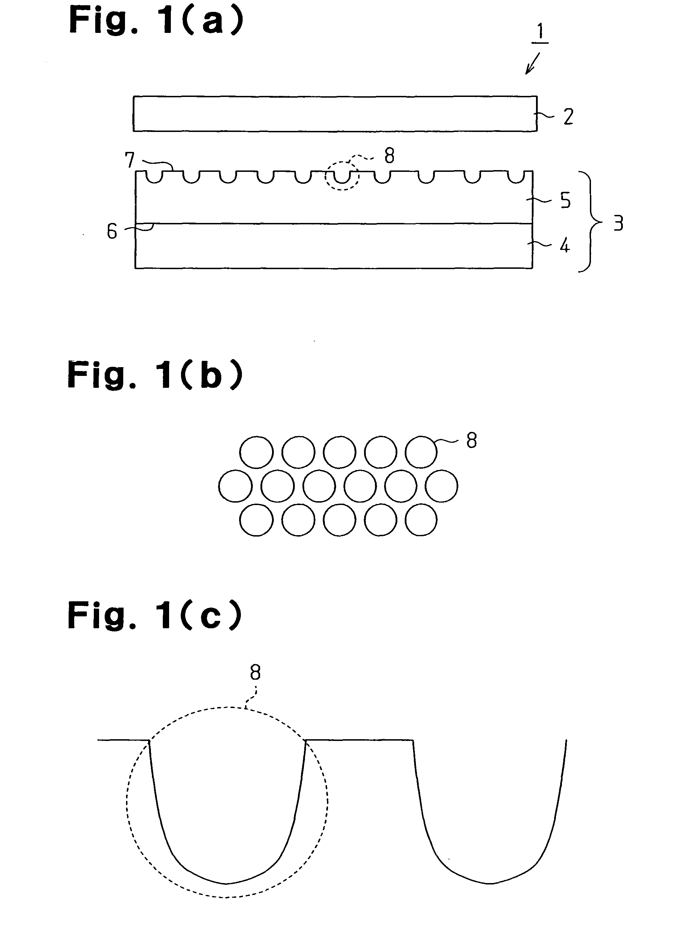

One embodiment of the present invention will now be described with reference to Figs. 1(a) to 2.

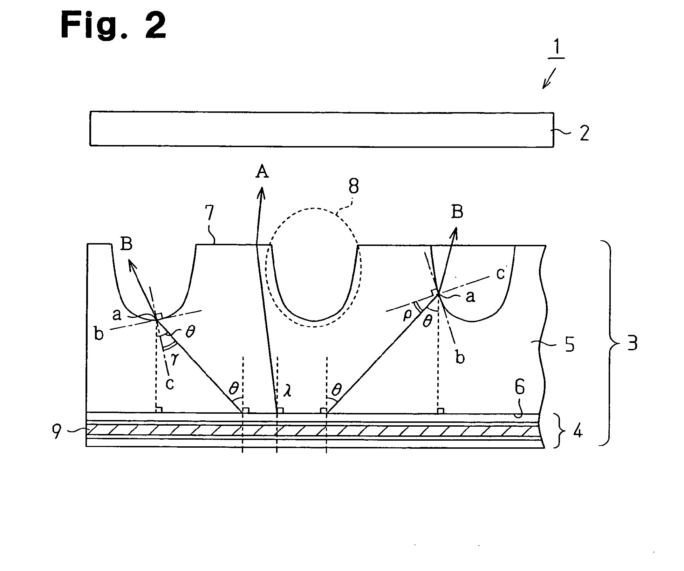

Figs. 1(a) and 2 show a transmissive liquid crystal display unit 1 that includes a liquid crystal member and an area light emitting device. In this embodiment, the liquid crystal member is a liquid crystal panel 2, and the area light emitting device is a backlight 3. The liquid crystal panel 2 has a conventional configuration, and, for example, includes pixels arranged in a matrix. Each pixel has color filters of red, blue and green. The liquid crystal panel 2 creates an image using the pixels. The backlight 3 is formed of a transparent substrate 5, and an organic electroluminescent element 4, which is an area light emitting element provided on the transparent substrate 5.

The transparent substrate 5 is made of glass and has a thickness of 500 µm. The transparent substrate 5 permits part of or all visible light to pass through. The transparent substrate 5 has an incidence surface 6 and a light exit surface 7, which are located at opposite sides of the transparent substrate 5 with respect to each other. The incidence surface 6 is contained in the interface between the organic electroluminescent element 4 and the transparent substrate 5. The light exit surface 7 is contained in the interface between the transparent substrate 5 and the air.

The incidence surface 6 is flat and faces the organic electroluminescent element 4. The light exit surface 7 faces away from the organic electroluminescent element 4, and is uneven with regularly arranged recesses 8. A part of the light exit surface 7 where no recesses 8 are formed is perpendicular to the thickness direction of the transparent substrate 5 and parallel to the incidence surface 6.

The recesses 8 have the same semi-spheroidal shape in the same size. As shown in Fig. 1(b), each recess 8 has a circular opening. The diameter of the opening and the depth of the recess 8 are both 250 µm. Except for the recesses 8 located at the periphery of the light exit surface 7, each recess 8 is surrounded by other six recesses 8. Each adjacent pair of the recesses 8 is spaced by 50 µm.

The recesses 8 are formed in the following manner. First, the transparent substrate 5, on which the organic electroluminescent element 4 is formed, is prepared. Before the recesses 8 are formed, the light exit surface 7 is perpendicular to the thickness direction of the transparent substrate 5 and parallel to the incidence surface 6. To prevent the organic electroluminescent element 4 from being scratched, the organic electroluminescent element 4 is sealed with a sealing member (not shown). Then, a part of the light exit surface 7 other than sections corresponding to the recesses 8 is protected with a mask. In this state, the light exit surface 7 is sandblasted. Accordingly, the portions of the light exit surface 7 that are not protected with the mask are ground so that the recesses 8 are formed. The mask is removed after the sandblasting.

Since the recesses 8 are formed in the above described manner, each section of the light exit surface 7 between an adjacent pair of the recesses 8 is not ground with sandblasting media, and stays perpendicular to the thickness direction of the transparent substrate 5 and parallel to the incidence surface 6.

The organic electroluminescent element 4 includes a flat transparent electrode made of indium tin oxide (ITO), an organic layer including a flat light emitting layer 9, and a flat metal electrode, which are subsequently formed on the transparent substrate 5. When voltage applied to the transparent electrode and the metal electrode, the entire light emitting layer 9 of the organic electroluminescent element 4 simultaneously emit light of the same color. In this embodiment, the light emitting layer 9 emits white light. Light emitted from the light emitting layer 9 advances to the transparent substrate 5 through the incidence surface 6 and then advances to the outside of the transparent substrate 5 through the light exit surface 7. In other words, the backlight 3 emits light emitted from the organic electroluminescent element 4 through the light exit surface 7.

The operation of the liquid crystal display unit 1 will now be described with reference to Fig. 2.

Since the light emitting layer 9 is flat, emission points on the organic electroluminescent element 4 are assumed to continuously exist on a plane parallel to the incidence surface 6 of the transparent substrate 5. Each emission point emits light evenly in all directions. Therefore, light emitted from the light emitting layer 9 enters the incidence surface 6 at every angle.

An arrow A in Fig. 2 represents a ray of a portion of light from the back of the incidence surface 6. The emission angle of the ray of the arrow A is less than the critical angle at the interface between the transparent substrate 5 and air. If the ray of the arrow A reaches the back of the light exit surface 7 where no recesses 8 are formed, the ray is not totally reflected on the interface between the transparent substrate 5 and air and exits the substrate 5 through the light exit surface 7.

Arrows B in Fig. 2 represent rays of portions of light from the back of the incidence surface 6. The emission angles of the rays of the arrows B are equal to or greater than the critical angle at the interface between the transparent substrate 5 and air. If the rays of the arrows B reach the back of the light exit surface 7 where no recesses 8 are formed, the rays are totally reflected on the interface between the transparent substrate 5 and air and does not exit the substrate 5 through the light exit surface 7. However, depending on the conditions, the rays represented by the arrows B, which reach the back of the light exit surface 7 where the recesses 8 are formed, are not totally reflected on the interface between the transparent substrate 5 and air but exit the substrate 5 through the light exit surface 7. This is because whether light that reaches the back of the light exit surface 7 where the recess 8 is formed is totally reflected is determined by an incident angle (for example, an angle y and an angle p in Fig. 2) relative to a tangent plane (for example, planes containing lines b in Fig. 2) at the point of incidence (for example, points a in Fig. 2). That is, as long as the incidence angle is less than the critical angle, even if the emission angle is equal to or greater than the critical angle, light is not totally reflected on the interface between the transparent substrate 5 and air but exits the substrate 5 through the light exit surface 7. In this manner, light that would not be emitted from the light exit surface 7 if no recesses 8 were formed is permitted to exit the substrate 5 through the light exit surface 7. Accordingly, light emitted from the organic electroluminescent element 4 is efficiently emitted.

This embodiment provides the following advantages.
(1) According to the illustrated embodiment, even if the emission angle at the back of the incidence surface 6 is greater than the critical angle of the interface between the transparent substrate 5 and air, a part of such light is not totally reflected on the interface but exits the substrate 5 through the light exit surface 7. Therefore, light emitted from the organic electroluminescent element 4 is efficiently emitted.
(2) Each recess 8 formed in the light exit surface 7 is semi-spheroidal shape and has rotation symmetry. Therefore, any light that reaches the back of the light exit surface 7 where the recess 8 is formed behaves in the same manner regardless of the direction of incidence.
(3) The recesses 8 are regularly formed so that each recess 8 is surrounded by other six of the recesses 8. That is, the recesses 8 are arranged in the densest manner. The illustrated embodiment therefore maximizes the advantages of the recesses 8.
(4) Instead of sandblasting, the recesses 8 may be etched through photolithography. However, photolithography requires a relatively great number of processes compared to sandblasting, which only has the masking process and the blasting process. That is, the formation of the recesses 8 using sandblasting is simpler than a method using photolithography. If photolithography is used, a pattern made of a photosensitive material needs to be formed on the transparent substrate 5 through a number of processes: a process for forming a layer of the photosensitive material on the transparent substrate 5; a process of pre-baking; a process for forming a latent image in the photosensitive layer through irradiation of light; a developing process; and a post-baking process. In addition, if photolithography is used, the number of types of materials that can be used for the sealing material is significantly limited. Also, means for preventing chemical agents used in photolithography from entering the organic electroluminescent element 4 is required.
(5) A part of the light exit surface 7 where no recesses 8 are formed is perpendicular to the thickness direction of the transparent substrate 5 and parallel to the incidence surface 6. Therefore, when light the emission angle of which at the back of the incidence surface 6 is less than the critical angle at the interface between the exit substrate 5 and air reaches such part, the light is not totally reflected but exits the substrate 5 through the light exit surface 7.
(6) A part of the light exit surface 7 where no recesses 8 are formed is not divided but formed continuously. Therefore, stress applied on the transparent substrate 5 during installment or use is spread out over the entire part of the light exit surface 7 where no recesses 8 are formed. Therefore, the mechanical strength of the transparent substrate 5 is not significantly reduced by forming the recesses 8 in the transparent substrate 5.
(7) The backlight 3 efficiently emits light emitted from the organic electroluminescent element 4. Therefore, the liquid crystal display unit 1 with the backlight 3 is capable of improving the viewability of displayed images.
(8) The recesses 8 are easily formed through sandblasting on the transparent substrate 5, on which the organic electroluminescent element 4 is formed in advance.
(9) A case where a film having recesses is provided on the transparent substrate 5 instead of forming the recesses 8 in the light exit surface 7 of the transparent substrate 5 will now be discussed. This configuration seemingly permits light emitted from the organic electroluminescent element 4 to be efficiently emitted by the backlight. However, in reality, since a part of light is reflected on the interface between the transparent substrate 5 and the film, light emitted from the organic electroluminescent element 4 is not as efficiently emitted by the backlight as the illustrated embodiment. That is, the number of interfaces between substances of different refractive indexes is preferably minimized in the path of light that is emitted from the organic electroluminescent element 4 and emitted from the backlight.

It should be apparent to those skilled in the art that the present invention may be embodied in many other specific forms without departing from the spirit of scope of the invention. Particularly, it should be understood that the invention may be embodied in the following forms.

The area light emitting device forming the backlight 3, or the organic electroluminescent element 4, may be replaced by an inorganic electroluminescent element. This modification also has the advantages of the illustrated embodiment.

In the illustrated embodiment, the recesses 8 are formed in the transparent substrate 5, which has been formed as a flat plate. However, the recesses 8 may be formed at the same time when the transparent substrate 5 is molded using a mold. This modification also has the advantages of the illustrated embodiment.

In the illustrated embodiment, the recesses 8 are formed through sandblasting. However, the recesses 8 may be formed through etching. This modification also has the advantages of the illustrated embodiment. When the recesses 8 are formed through etching, photolithography is typically employed. However, the formation of the recesses 8 through photolithography is more complicated than a method using sandblasting.

In the illustrated embodiment, the area light emitting device is used as the backlight 3 of the liquid crystal display unit 1. The area light emitting device may be applied to other purposes such as lighting devices. This modification also has the advantages of the illustrated embodiment.

The color of light emitted by the organic electroluminescent element 4 need not be white, but may be any color. This modification also has the advantages of the illustrated embodiment.

The transparent substrate 5 need not be made of glass, but may be made of a resin. This modification also has the advantages of the illustrated embodiment.

The present examples and embodiments are to be considered as illustrative and not restrictive and the invention is not to be limited to the details given herein, but may be modified within the scope and equivalence of the appended claims.

A backlight in a liquid crystal display unit according to the present invention has a transparent substrate and an organic electroluminescent element provided on the transparent substrate. The backlight emits light emitted from the organic electroluminescent element from a light exit surface of the transparent substrate. A plurality of recesses are formed in the light exit surface. A part of the light exit surface between each adjacent pair of the recesses includes a plane that is perpendicular to the thickness direction of the transparent substrate. The backlight permits light emitted from the organic electroluminescent element to be efficiently emitted.

## Claims

1. An area light emitting device, **characterized by** a transparent substrate having a predetermined thickness and an area light emitting element provided on the transparent substrate, wherein the transparent substrate includes a light exit surface, wherein light emitted from the element advances through the transparent substrate and exits the device through the light exit surface, wherein a plurality of recesses are located on the light exit surface, and wherein a part of the light exit surface between each adjacent pair of the recesses includes a plane that is perpendicular to the thickness direction of the transparent substrate.

2. The area light emitting device according to claim 1, **characterized in that**, except for the recesses located at the periphery of the light exit surface, each recess is surrounded by other six recesses.

3. The area light emitting device according to claim 1 or 2, **characterized in that** the element is an organic electroluminescent element.

4. The area light emitting device according to any one of claims 1 to 3, **characterized in that** a cross-section of each recess along a plane that is perpendicular to the thickness direction of the transparent substrate is circular.

5. The area light emitting device according to claim 4, **characterized in that** each recess has a circular opening, and wherein the diameter of the opening is approximately half the thickness of the transparent substrate.

6. The area light emitting device according to any one of claims 1 to 5, **characterized in that** the depth of each recess is approximately half the thickness of the transparent substrate.

7. The area light emitting device according to any one of claims 1 to 6, **characterized in that** the cross-sectional area of each recess decreases toward the element.

8. The area light emitting device according to any one of claims 1 to 7, **characterized in that** the bottom of each recess is shaped as a curved surface.

9. A liquid crystal display unit, **characterized by** a liquid crystal member and the area light emitting device according to any one of claims 1 to 8, wherein the liquid crystal member creates images by using light emitted by the area light emitting device.

10. An area light emitting device, **characterized by** a transparent substrate and an area light emitting element provided on the transparent substrate, wherein the transparent substrate includes a light exit surface, wherein light emitted from the element advances through the transparent substrate and exits the device through the light exit surface, wherein a plurality of recesses are located on the light exit surface, the recesses being formed by processing the light exit surface , and wherein a part of the light exit surface between each adjacent pair of the recesses includes a portion that is not subjected to the process for forming the recesses.

11. The area light emitting device according to claim 10, **characterized in that** the process for forming the recesses is sandblasting.

12. The area light emitting device according to claim 11, **characterized in that** the sandblasting is performed on the light exit surface of the transparent substrate, on which the element has been formed in advance.

13. The area light emitting device according to any one of claims 10 to 12, **characterized in that**, except for the recesses located at the periphery of the light exit surface, each recess is surrounded by other six recesses.

14. The area light emitting device according to any one of claims 10 to 13, **characterized in that** the element is an organic electroluminescent element.

15. A liquid crystal display unit, **characterized by** a liquid crystal member and the area light emitting device according to any one of claims 10 to 14, wherein the liquid crystal member creates images by using light emitted by the area light emitting device.

16. A method for manufacturing an area light emitting device, wherein the device includes a transparent substrate and an area light emitting element provided on the transparent substrate, wherein the transparent substrate includes a light exit surface, and wherein light emitted from the element advances through the transparent substrate and exits the device through the light exit surface, the method **characterized by**:
masking a part of the light exit surface with a mask;
sandblasting the light exit surface, which is masked, thereby forming a plurality of recesses in the light exit surface; and
removing the mask after the sandblasting.

17. A method for manufacturing an area light emitting device, wherein the device includes a transparent substrate and an organic electroluminescent element, wherein the transparent substrate includes a light exit surface, and wherein light emitted from the element advances through the transparent substrate and exits the device through the light exit surface, the method **characterized by**:
forming the organic electroluminescent element on the transparent substrate;
sealing the organic electroluminescent element on the transparent substrate;
masking a part of the light exit surface of the transparent substrate, on which the organic electroluminescent element is formed , with a mask;
sandblasting the light exit surface, which is masked, thereby forming a plurality of recesses in the light exit surface; and
removing the mask after the sandblasting.
